# EUROPEAN PATENT APPLICATION

(11) **EP 4 811 417 A2**
(43) Date of publication of application: **23.09.2026**
(21) Application number: 26165017.0
(22) Date of filing: 16.03.2026
(51) Int. Cl.: H01J 37/20, G01Q 10/04, G02B 21/26, G03F 7/00

(54) **STAGE DEVICE, AND CHARGED PARTICLE BEAM APPARATUS AND OPTICAL INSPECTION APPARATUS INCLUDING SAME**

(30) Priority: 17.03.2025 WO PCT/JP2025/010132
(71) Applicant: Hitachi High-Tech Corporation, Minato-ku Tokyo 105-6409 (JP)
(72) Inventor: KATO, Takanori, Tokyo 1008280 (JP); MIZUOCHI, Masaki, Tokyo 1056409 (JP); TAKAHASHI, Motohiro, Tokyo 1008280 (JP); OGAWA, Hironori, Tokyo 1008280 (JP)
(74) Representative: MERH-IP Matias Erny Reichl Hoffmann Patentanwälte PartG mbB

(57) **Abstract**

A stage device capable of preventing elastic deformation of a stage, and a charged particle beam apparatus and an optical inspection apparatus including the same are provided. The stage device includes: a stage configured to hold a sample; a horizontal drive unit configured to drive the stage in a horizontal direction; a vertical drive unit configured to drive the stage in a vertical direction; and a control unit configured to control the horizontal drive unit and the vertical drive unit. The control unit inverts phases of the horizontal drive unit and the vertical drive unit at a specific frequency calculated based on a frequency property when the stage is driven in the horizontal direction and a frequency property when the stage is driven in the vertical direction.

## Description

### Technical Field

The present invention relates to a stage device used in a charged particle beam apparatus or an optical inspection apparatus, and more particularly to vibration prevention of the stage device.

### Background Art

A stage device used in a charged particle beam apparatus or an optical inspection apparatus includes a drive source, such as a motor, in each of three axial directions orthogonal to one another in order to move a stage holding a sample to a predetermined position. When an action point of a driving force by the drive source is shifted from a position of a gravity center of the stage, for example, when the motor that generates a driving force in a horizontal direction is provided below the position of the gravity center of the stage in order to prevent an influence of an electromagnetic field leaking from the motor on a charged particle beam with which the sample is irradiated, a moment is generated around an axis orthogonal to a driving direction and the stage vibrates, result in a decrease in positioning accuracy.

PTL 1 discloses controlling a drive source such that a driving force in a horizontal direction acts against a moment generated when an action point of a driving force in a vertical direction shifts from a position of a gravity center of a stage. For example, when a counterclockwise moment is generated in the stage by the driving force in the horizontal direction, a drive source is controlled to rotate the stage clockwise by the driving force in the vertical direction.

### Citation List

### Patent Literature

PTL 1: JP2017-11008A

### Summary of Invention

### Technical Problem

However, in PTL 1, consideration is not given to a vibration caused by elastic deformation of the stage. When the driving force in the vertical direction acts against the moment generated by the driving force in the horizontal direction, the stage is elastically deformed except the action point of the driving force in the vertical direction. Then, the vibration is amplified at a frequency at which elastic deformation caused by the driving force in the horizontal direction and elastic deformation caused by the driving force in the vertical direction are in the same phase, and the positioning accuracy greatly decreases.

Therefore, an object of the invention is to provide a stage device capable of preventing elastic deformation of a stage, and a charged particle beam apparatus and an optical inspection apparatus including the same.

### Solution to Problem

In order to achieve the above objects, the invention provides a stage device including: a stage configured to hold a sample; a horizontal drive unit configured to drive the stage in a horizontal direction; a vertical drive unit configured to drive the stage in a vertical direction; and a control unit configured to control the horizontal drive unit and the vertical drive unit. The control unit inverts phases of the horizontal drive unit and the vertical drive unit at a specific frequency calculated based on a frequency property when the stage is driven in the horizontal direction and a frequency property when the stage is driven in the vertical direction.

In addition, the invention provides a charged particle beam apparatus including the stage device and configured to generate an observation image by irradiating the sample with a charged particle beam.

Further, the invention provides an optical inspection apparatus including the stage device and configured to generate an observation image by irradiating the sample with light.

### Advantageous Effects of Invention

According to the invention, it is possible to provide a stage device capable of preventing elastic deformation of a stage, and a charged particle beam apparatus and an optical inspection apparatus including the same.

### Brief Description of Drawings

[FIG. 1] FIG. 1 is an overall configuration diagram of a stage device according to the invention.
[FIG. 2] FIG. 2 is a diagram showing a moment generated by a driving force in a horizontal direction.
[FIG. 3] FIG. 3 is a diagram showing elastic deformation generated when a driving force in a vertical direction acts against the moment.
[FIG. 4] FIG. 4 is a diagram showing vibrations caused by the moment or the elastic deformation.
[FIG. 5] FIG. 5 is a diagram showing a flow of processing according to Embodiment 1.
[FIG. 6] FIG. 6 is a diagram showing an example of a flow of processing of setting a phase inversion filter.
[FIG. 7] FIG. 7 is a diagram showing calculation of parameters of the phase inversion filter.
[FIG. 8] FIG. 8 is a diagram showing frequency properties of the phase inversion filter.
[FIG. 9] FIG. 9 is a diagram showing an example of a setting screen for automatically adjusting the parameters of the phase inversion filter.
[FIG. 10] FIG. 10 is a configuration diagram of a charged particle beam apparatus including the stage device according to the invention.
[FIG. 11] FIG. 11 is a configuration diagram of an optical inspection apparatus including the stage device according to the invention.
[FIG. 12] FIG. 12 is a diagram showing an example of a configuration of a floating stage.

### Description of Embodiments

### [Embodiment 1]

Hereinafter, the present embodiment will be described with reference to the drawings. A horizontal direction is represented by an X axis and a Y axis, a vertical direction is represented by a Z axis, and the X axis, the Y axis, and the Z axis are orthogonal to one another.

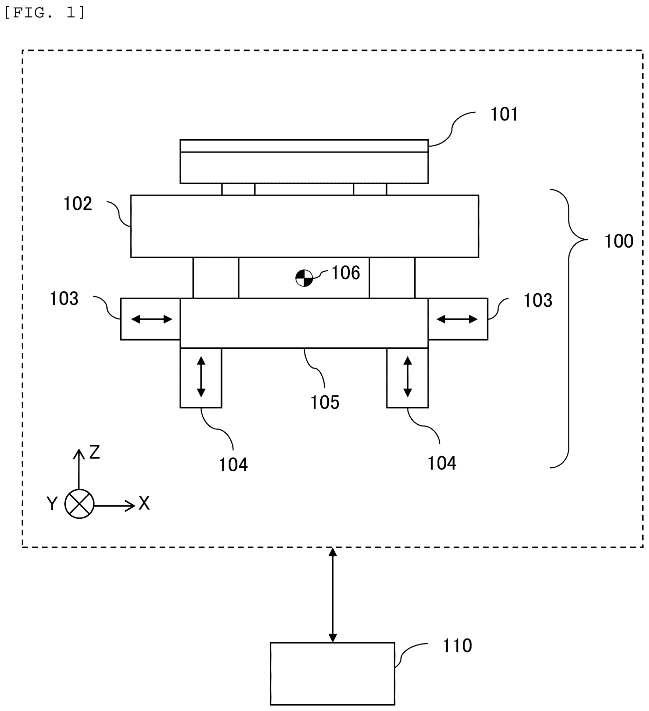

FIG. 1 is an overall configuration diagram of a stage device. The stage device includes a stage unit 100 and a control unit 110. The stage unit 100 includes a top table 102, a horizontal drive unit 103, a vertical drive unit 104, a drive table 105, and a stage gravity center 106.

The top table 102 holds a sample 101, and is connected to the drive table 105 provided below the stage gravity center 106. A position of the top table 102 is measured by a position measuring instrument (not shown), for example, a laser displacement meter or a linear scaler, and is transmitted to the control unit 110.

The horizontal drive unit 103 is, for example, a motor, and drives the drive table 105 in the horizontal direction. Although FIG. 1 shows driving only in an X-axis direction, the horizontal drive unit 103 also drives the drive table 105 in a Y-axis direction.

The vertical drive unit 104 is, for example, a motor, and drives the drive table 105 in the vertical direction. The drive table 105 can be rotated clockwise by driving a left side of the vertical drive unit 104 upward and driving a right side thereof downward.

The drive table 105 is driven by the horizontal drive unit 103 and the vertical drive unit 104, and is connected to the top table 102. That is, a position of the top table 102 is moved by driving the drive table 105.

The control unit 110 is a so-called computer, and controls the horizontal drive unit 103 and the vertical drive unit 104 based on the position of the top table 102. The control unit 110 controls the horizontal drive unit 103 and the vertical drive unit 104 to move the drive table 105 and also move the top table 102 connected to the drive table 105.

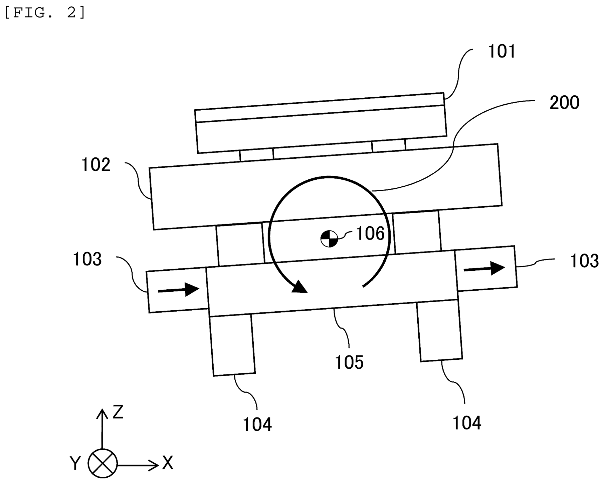

As shown in FIG. 2, when an action point of a driving force by the horizontal drive unit 103 is shifted from the stage gravity center 106, a moment 200 is generated around the Y axis, which is an axis orthogonal to a driving direction. Due to the generation of the moment 200, the drive table 105 and the top table 102 vibrate, and the sample 101 held by the top table 102 also vibrates.

In order to prevent such a vibration, the vertical drive unit 104 is controlled to act against the moment 200 generated counterclockwise. That is, the moment 200 can be prevented by driving the left side of the vertical drive unit 104 upward and driving the right side thereof downward, so as to rotate the drive table 105 clockwise. However, the drive table 105 is elastically deformed except the action point of the driving force in the vertical direction.

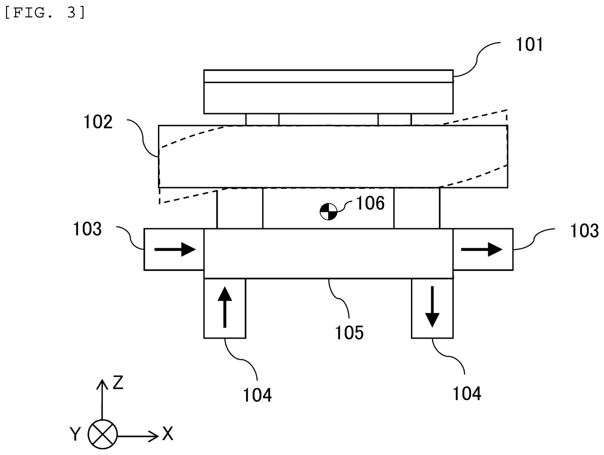

With reference to FIG. 3, the elastic deformation generated when the driving force in the vertical direction is made to act against the moment 200 will be described. Although the moment 200 shown in FIG. 2 can be prevented by driving the left side of the vertical drive unit 104 upward and driving the right side thereof downward, the drive table 105 is elastically deformed as shown by a dotted line. Then, the vibration is amplified at a frequency at which elastic deformation caused by the driving force in the horizontal direction and elastic deformation caused by the driving force in the vertical direction are in the same phase.

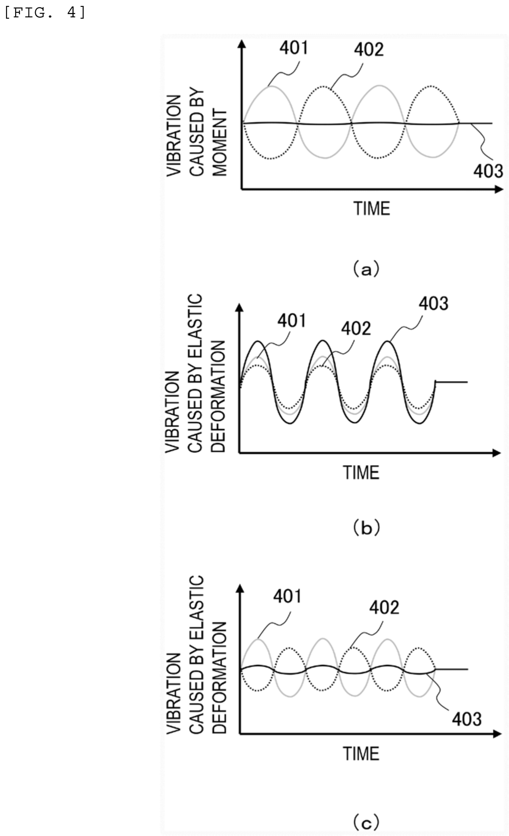

The vibration caused by the moment or the elastic deformation will be described with reference to FIG. 4. (a) of FIG. 4 shows a temporal change in vibration caused by a moment, and shows a case where a moment generated by the driving force in the horizontal direction acts against the driving force in the vertical direction. That is, since a phase of a horizontal driving vibration 401 and a phase of a vertical driving vibration 402 are inverted, a synthetic vibration 403 obtained by combining the two vibrations is prevented.

(b) of FIG. 4 shows a temporal change in vibration caused by elastic deformation, and shows a case where the phase of the horizontal driving vibration 401 coincides with the phase of the vertical driving vibration 402. When the phases of the two vibrations coincide with each other, the synthetic vibration 403 is amplified, and positioning accuracy greatly decreases. A frequency at which the phase of the horizontal driving vibration 401 and the phase of the vertical driving vibration 402 coincide with each other varies depending on parameters related to the drive table 105. For example, a material and a shape of the drive table 105, positions of the action points of the driving force in the horizontal direction and the driving force in the vertical direction, and the like are the parameters related to the drive table 105.

(c) of FIG. 4 shows a temporal change in vibration caused by elastic deformation, and shows a case where the phases of the horizontal driving vibration 401 and the vertical driving vibration 402 are inverted. By inverting phases of the driving force in the horizontal direction and the driving force in the vertical direction at a specific frequency at which the phases of the two vibrations determined by the parameters related to the drive table 105 coincide with each other, the synthetic vibration 403 caused by the elastic deformation is prevented, and the positioning accuracy can be improved.

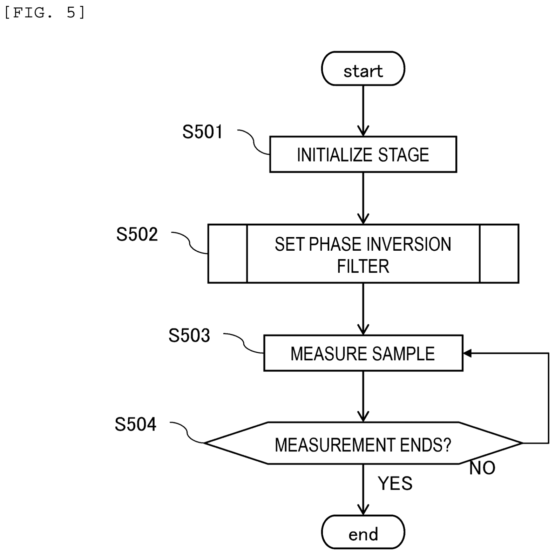

An example of a flow of processing according to Embodiment 1 will be described for each processing step with reference to FIG. 5.

### (S501)

The control unit 110 controls the horizontal drive unit 103 and the vertical drive unit 104 to move the top table 102 to an initial position.

### (S502)

The control unit 110 sets a phase inversion filter. The phase inversion filter is a filter that inverts the phases of the driving force in the horizontal direction and the driving force in the vertical direction at a specific frequency at which phases of a horizontal driving vibration and a vertical driving vibration coincide with each other. A phase inversion filter F(s) is expressed by, for example, the following formula. $F \left(s\right) = {K}_{nf} \left\{{F}_{nf}\left(s\right)-{K}_{bpf}{F}_{bpf}\left(s\right)\right\}$

Here, Knf and Kbpf are coefficients, Fnf(s) is a notch filter, and Fbpf(s) is a bandpass filter.

The notch filter Fnf(s) is a filter that prevents a vibration at a specific frequency, and is expressed by the following formula. ${F}_{nf} \left(s\right) = \frac{{s}^{2} + {ω}^{2}}{{s}^{2} + 2 ζωs + {ω}^{2}}$

Here, ω is a natural angular frequency, and ζ is an attenuation coefficient.

The bandpass filter Fbpf(s) is a filter that passes the vibration at the specific frequency, and is expressed by the following formula. ${F}_{bpf} \left(s\right) = \frac{2 ζωs}{{s}^{2} + 2 ζωs + {ω}^{2}}$

When the control unit 110 sets the phase inversion filter, the vibration caused by the elastic deformation can be prevented. The number of stages in the phase inversion filter may be changed according to the number of specific frequencies at which the phases are inverted. That is, the phase inversion filter F(s) in Math. 1 is composed of two terms, but is composed of four terms when the number of specific frequencies is two and six terms when the number of specific frequencies is three. In addition, the phase inversion filter may be implemented using a general computer language such as C language, or may be implemented as a control circuit using a field programmable gate array (FPGA) or the like.

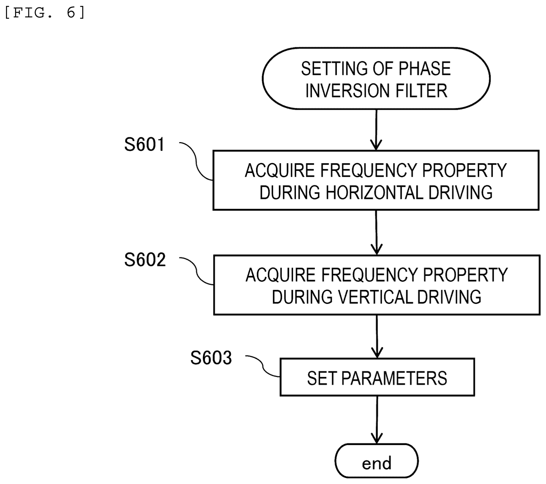

An example of a flow of processing of setting the phase inversion filter will be described for each processing step with reference to FIG. 6.

### (S601)

The control unit 110 acquires frequency properties when the drive table 105 is horizontally driven. For example, the frequency properties during the horizontal driving is acquired by measuring a temporal change in position of the top table 102 when the drive table 105 is vibrated using the horizontal drive unit 103 every time a vibration frequency of the horizontal drive unit 103 is changed.

### (S602)

The control unit 110 acquires frequency properties when the drive table 105 is vertically driven. For example, the frequency properties during the vertical driving is acquired by measuring a temporal change in position of the top table 102 when the drive table 105 is vibrated using the vertical drive unit 104 every time a vibration frequency of the vertical drive unit 104 is changed.

### (S603)

The control unit 110 sets ω, ζ, Knf, and Kbpf, which are parameters of the phase inversion filter F(s), based on the frequency properties during the horizontal driving and during the vertical driving acquired in S601 and S602. For example, the parameters are set so as to minimize a synthetic vibration amount obtained by combining a vibration amount during the horizontal driving and a vibration amount during the vertical driving.

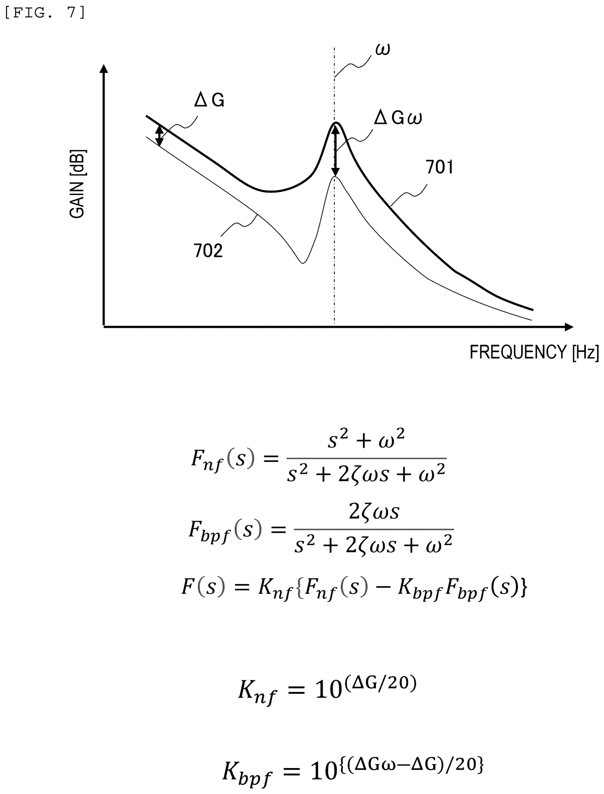

An example of setting the parameters of the phase inversion filter will be described with reference to FIG. 7. FIG. 7 shows an example of a frequency property during horizontal driving 701 and a frequency property during vertical driving 702. The natural angular frequency ω is calculated based on a position of a peak of the frequency property, and the attenuation coefficient ζ is calculated based on a sharpness of the peak. Further, the coefficients Knf and Kbpf are calculated based on a gain difference ΔGω at ω between the frequency property during the horizontal driving 701 and the frequency property during the vertical driving 702 and a gain difference ΔG at a baseline according to the following formulas. ${K}_{nf} = {10}^{\left(ΔG/20\right)}$ ${K}_{bpf} = {10}^{\left\{\left(ΔGω-ΔG\right)/20\right\}}$

By setting the coefficients Knf and Kbpf using the above formulas, an amplitude of the horizontal driving vibration and an amplitude of the vertical driving vibration are the same, and the two vibrations cancel each other.

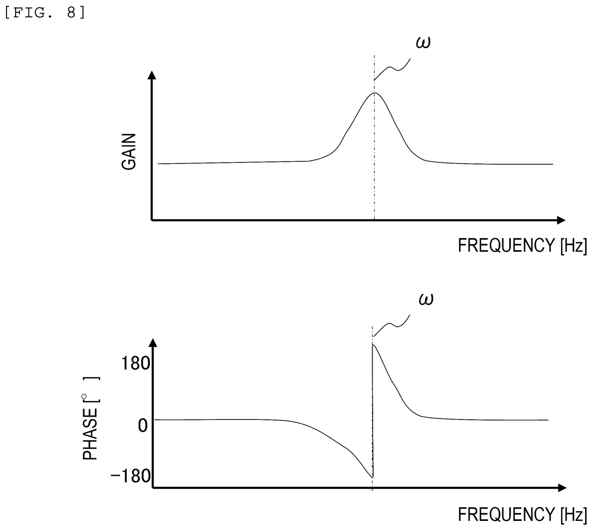

The phase inversion filter is set according to the flow of the processing described with reference to FIG. 6. The set phase inversion filter has frequency properties shown in FIG. 8. That is, the phase can be advanced by 180° near the natural angular frequency ω. In addition, since a phase property is 0° and the gain is constant except near the natural angular frequency ω, a vibration except near the natural angular frequency ω is not influenced. Automatic adjustment of the parameters of the phase inversion filter may be set by an operator via a setting screen.

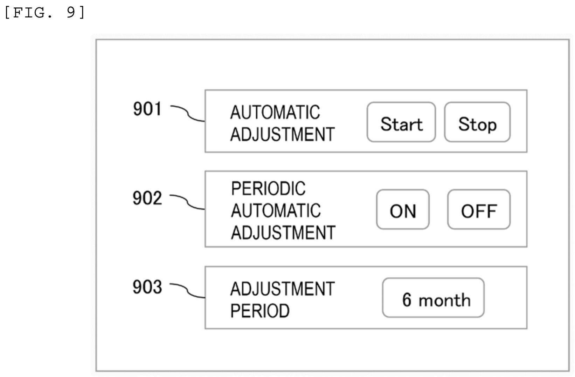

An example of a setting screen for automatically adjusting the parameters of the phase inversion filter will be described with reference to FIG. 9. A screen shown in FIG. 9 includes an automatic adjustment switching portion 901, a periodic adjustment switching portion 902, and an adjustment period setting portion 903. The automatic adjustment switching portion 901 is used to switch whether to execute automatic adjustment. The periodic adjustment switching portion 902 is used to switch whether to execute periodic automatic adjustment. A period for executing the periodic automatic adjustment is input to the adjustment period setting portion 903. Returns to the description of FIG. 5. The control unit 110 periodically adjusts the parameters of the phase inversion filter according to the setting on the screen in FIG. 9. By periodically adjusting the parameters, the elastic deformation can be prevented over a long period of time.

### (S503)

The sample 101 loaded on the stage unit 100 is measured by a charged particle beam apparatus or an optical inspection apparatus. The measured sample 101 is unloaded from the stage unit 100.

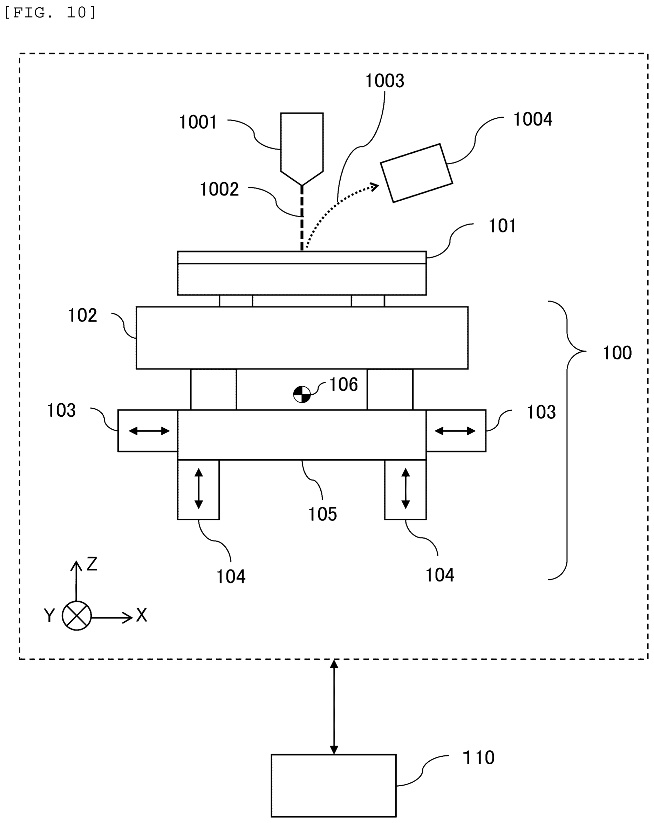

A configuration of the charged particle beam apparatus will be described with reference to FIG. 10. The charged particle beam apparatus includes an electron source 1001, an electron detector 1004, the stage unit 100, and the control unit 110. The electron source 1001 emits an electron beam 1002 which is a charged particle beam with which the sample 101 is irradiated. The electron detector 1004 detects secondary electrons 1003 emitted by the irradiation of the sample 101 with the electron beam 1002, and transmits a detection signal to the control unit 110. The control unit 110 generates an observation image of the sample 101 based on the transmitted detection signal.

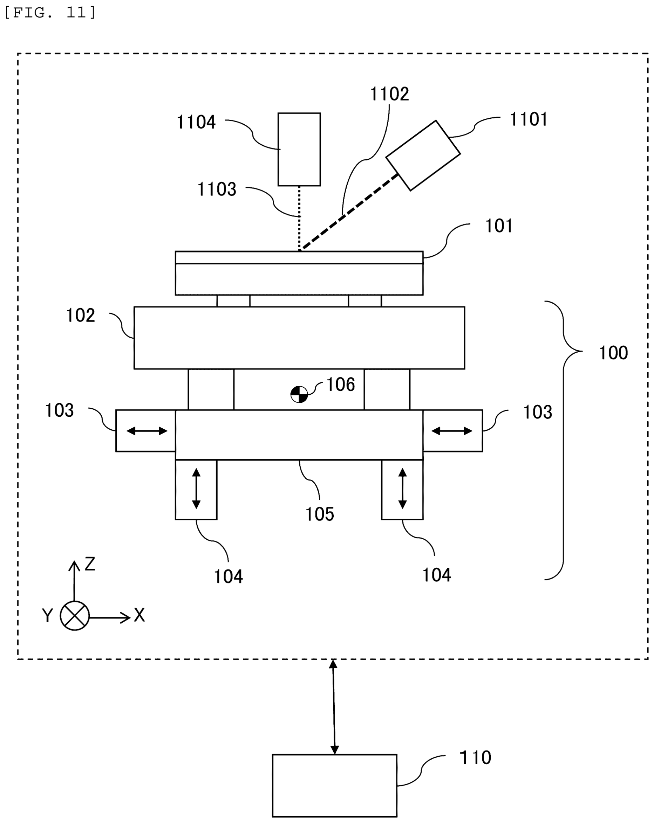

A configuration of the optical inspection apparatus will be described with reference to FIG. 11. The optical inspection apparatus includes a light source 1101, a photodetector 1104, the stage unit 100, and the control unit 110. The light source 1101 emits light 1102 with which the sample 101 is irradiated. The photodetector 1104 detects scattered light 1103 generated by the irradiation of the sample 101 with the light 1102, and transmits a detection signal to the control unit 110. The control unit 110 generates an observation image of the sample 101 based on the transmitted detection signal.

### (S504)

The control unit 110 determines whether the measurement ends. When the measurement ends, the flow of the processing ends, and when the measurement does not end, the processing returns to S503 and a new sample 101 is measured.

The flow of the processing described with reference to FIG. 5 enables the measurement of the sample 101 while preventing the elastic deformation of the stage. Further, since the elastic deformation of the stage is prevented, the positioning accuracy can be improved. The top table 102 and the drive table 105 are not limited to the configuration of being connected as shown in FIG. 1.

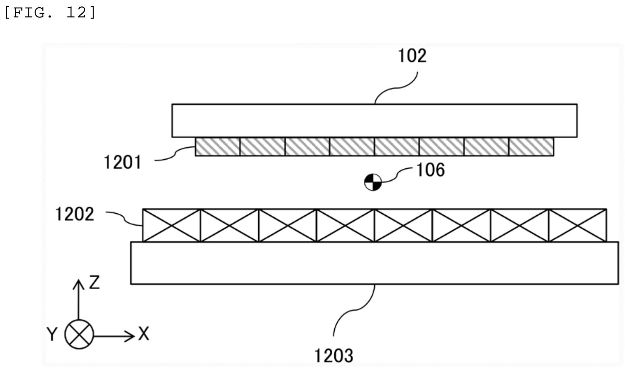

A configuration of a floating stage in which the top table 102 floats will be described with reference to FIG. 12. The floating stage includes the top table 102, a magnet 1201, a coil 1202, and a base 1203. The magnet 1201 is spread on a lower surface of the top table 102. The base 1203 is disposed below the top table 102. The coil 1202 is spread on an upper surface of the base 1203 and generates an electromagnetic force that repels a magnetic force of the magnet 1201.

That is, the magnetic force of the magnet 1201 repels the electromagnetic force generated by the coil 1202, so that the top table 102 floats above the base 1203. The control unit 110 can move the top table 102 by controlling the electromagnetic force of the coil 1202. Then, elastic deformation of the floating stage can be prevented by setting phase inversion parameters according to the flow of the processing in FIG. 6.

The stage device according to the invention is not limited to the above embodiment and can be embodied by modifying components without departing from the gist of the invention. A plurality of components disclosed in the above-described embodiment may be combined as appropriate. A part of components may be deleted from all components disclosed in the above embodiment.

### Reference Signs List

stage unit 100
sample 101
top table 102
horizontal drive unit 103
vertical drive unit 104
drive table 105
stage gravity center 106
control unit 110
moment 200
horizontal driving vibration 401
vertical driving vibration 402
synthetic vibration 403
frequency property during horizontal driving 701
frequency property during vertical driving 702
automatic adjustment switching portion 901
periodic adjustment switching portion 902
adjustment period setting portion 903
electron source 1001
electron beam 1002
secondary electron 1003
electron detector 1004
light source 1101
light 1102
scattered light 1103
photodetector 1104
magnet 1201
coil 1202
base 1203

## Claims

1. A stage device comprising:
a stage configured to hold a sample;
a horizontal drive unit configured to drive the stage in a horizontal direction;
a vertical drive unit configured to drive the stage in a vertical direction; and
a control unit configured to control the horizontal drive unit and the vertical drive unit, wherein
the control unit inverts phases of the horizontal drive unit and the vertical drive unit at a specific frequency calculated based on a frequency property when the stage is driven in the horizontal direction and a frequency property when the stage is driven in the vertical direction.

2. The stage device according to claim 1, wherein
the control unit inverts the phases of the horizontal drive unit and the vertical drive unit at the specific frequency by using a filter obtained by combining a notch filter and a bandpass filter.

3. The stage device according to claim 2, wherein
the control unit sets a parameter used for the filter based on the frequency property.

4. The stage device according to claim 2, wherein
the control unit sets a coefficient by which the notch filter and the bandpass filter are multiplied such that a vibration amplitude caused by driving of the horizontal drive unit and a vibration amplitude caused by driving of the vertical drive unit are same at the specific frequency.

5. The stage device according to claim 2, wherein
the control unit periodically adjusts a parameter used for the filter.

6. The stage device according to claim 1, wherein
the horizontal drive unit and the vertical drive unit are disposed below a gravity center of the stage.

7. The stage device according to claim 1, wherein
the stage is a floating stage configured to float by a magnetic force.

8. A charged particle beam apparatus comprising:
the stage device according to claim 1, wherein
the charged particle beam apparatus is configured to generate an observation image by irradiating the sample with a charged particle beam.

9. An optical inspection apparatus comprising:
the stage device according to claim 1, wherein
the optical inspection apparatus is configured to generate an observation image by irradiating the sample with light.
